## Europäisches Patentamt

## European Patent Office

## Office européen des brevets

(19)

(11) Numéro de publication: **0 161 154**
**B1**

(12) **FASCICULE DE BREVET EUROPEEN**

(45) Date de publication du fascicule du brevet:
**16.08.89**

(51) Int. Cl.⁴: **H 03 F 3/45**

(21) Numéro de dépôt: **85400657.4**

(22) Date de dépôt: **02.04.85**

(54) Amplificateur à large bande à double contre-réaction de mode commun.

(30) Priorité: **06.04.84 FR 8405483**

(43) Date de publication de la demande:
**13.11.85 Bulletin 85/46**

(45) Mention de la délivrance du brevet:
**16.08.89 Bulletin 89/33**

(84) Etats contractants désignés:
**DE FR GB IT NL**

(56) Documents cités:
**FR-A- 2 318 534**
**FR-A- 2 535 546**
**US-A- 4 371 843**

(73) Titulaire: **SGS-THOMSON MICROELECTRONICS S.A., 7, Avenue Galliéni, F-94250 Gentilly (FR)**

(72) Inventeur: **Bernard, Patrick, THOMSON-CSF SCPI 173, bld Haussmann, F-75379 Paris Cedex 08 (FR)**

(74) Mandataire: **Rinuy, Santarelli, 14, avenue de la Grande Armée, F-75017 Paris (FR)**

**IEEE INTERNATIONAL SOLID-STATE CIRCUITS CONFERENCE, vol. 25, février 1982, pages 82,83,298, IEEE, New York, US; R.C. YEN et al.: "Data acquisition and conversion. An MOS switched capacitor sampling differential instrumentation amplifier"**

ACTORUM AG

## Description

La présente invention concerne les amplificateurs différentiels à large bande, par exemple de l'ordre de 20 mégahertz de largeur de bande.

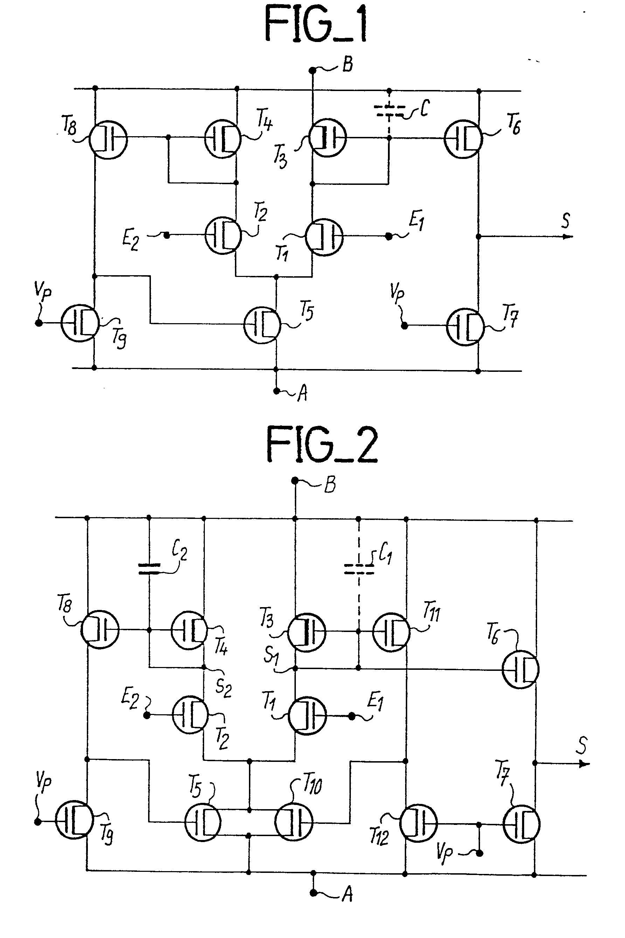

Un type d'amplificateur connu est représenté à la figure 1: il comprend un étage différentiel pour l'obtention d'un gain désiré et un étage suiveur de tension à gain unitaire, pour l'adaptation d'impédance par rapport à la charge qui sera placée en sortie. De plus, l'amplificateur comporte une branche de contre-réaction de mode commun par laquelle on réinjecte d'une certaine manière dans l'étage différentiel un signal représentant l'amplitude du signal présent sur l'une des sorties de l'état différentiel.

Plus précisément, sur le schéma de la figure 1, l'étage différentiel comprend une branche de polarisation commune alimentant en courant deux branches différentielles; les branches différentielles comprennent chacune un transistor MOS d'entrée (T1 pour la première branche, T2 pour la seconde) en série avec un transistor MOS de charge (T3, T4 respectivement) ayant sa grille reliée à sa source s'il s'agit d'un transistor de type déplété (à tension de seuil négative) ou sa grille reliée à son drain s'il s'agit d'un transistor enrichi (à tension de seuil positive); ici, T3 et T4 sont des transistors déplétés; les entrées E1 et E2 de l'étage différentiel sont les grilles des transistors T1 et T2; les sorties S1 et S2 sont respectivement le point de jonction des transistors T1 et T3 de la première branche et le point de jonction des transistors T2 et T4 de la seconde.

La branche de polarisation commune est constituée par un transistor MOS T5 relié entre une première borne d'alimentation A du circuit et les sources réunies des transistors d'entrées T1 et T2. Les branches différentielles sont reliées par les drains des transistors de charge T3 et T4 à une deuxième borne d'alimentation B.

L'étage suiveur d'adaptation d'impédance comprend deux transistors MOS T6 et T7 en série entre les bornes A et B, le transistor T7, relié à la borne A, recevant sur sa grille une tension de polarisation $V_p$ et le transistor T6, relié à la borne B, recevant sur sa grille la première sortie S1 de l'étage différentiel. La sortie S de l'amplificateur est prise au point de jonction du drain du transistor T7 et de la source du transistor T6.

La branche de contre-réaction de mode commun, qui sert à stabiliser les niveaux de sortie sur les bornes S1 et S2 en modifiant le courant dans la branche de polarisation commune. comprend deux transistors T8 et T9 montés comme un étage suiveur entre la deuxième sortie S2 de l'étage différentiel et la grille de commande du transistor T5 de la branche commune: le transistor T8 a son drain relié à la borne B, sa grille au point S2. sa source au drain du transistor T9 et à la grille du transistor T5; le transistor T9 a sa source reliée à la borne A et sa grille alimentée par une tension de polarisation qui peut être la même ($V_p$) que celle du transistor T7.

Un autre exemple d'amplificateur différentiel comportant un unique transistor dans ladite branche commune est décrit dans le document US-A4 371 843.

Dans d'autres schémas d'amplificateurs, il est connu qu'on peut aussi prévoir une double contre-réaction de mode commun en plaçant un autre transistor en parallèle sur le transistor T5, cet autre transistor ayant sa grille commandée par la sortie S1 à travers un suiveur de tension.

Par ailleurs, un problème essentiel dans les amplificateurs à large bande est d'éviter leur oscillation à des fréquences élevées lorsqu'ils sont bouclés en gain unitaire. Par exemple, un amplificateur présentant un gain supérieur à l'unité dans une bande passante de l'ordre de 20 MHz pourra présenter un risque d'oscillation à 80 MHz si sa courbe de réponse en fréquence est telle qu'à 80 MHz il possède un gain supérieur ou égal à 1 tout en présentant une rotation de phase de 180° à cette fréquence.

Pour éviter ce genre d'oscillation, on est conduit à diminuer artificiellement la fréquence de coupure principale de l'amplificateur; à titre d'exemple, on a représenté à la figure 1 l'introduction d'une capacité C1 (en pointillés) que l'on a pu essayer de placer entre la sortie S1 (celle qui attaque l'étage suiveur) et la deuxième borne d'alimentation B pour réduire le risque d'oscillation.

Mais on se heurte vite à une difficulté: en plaçant cette capacité, on diminue globalement la bande passante de l'amplificateur et on ne remplit donc plus les spécifications voulues, notamment en ce qui concerne le temps de montée de l'amplificateur. Ainsi, en voulant supprimer le risque d'oscillation à 80 MHz pour un amplificateur dont la bande passante s'étendait jusqu'à 20 MHz, on est amené à descendre la bande passante au-dessous de 20 MHz, ce qu'on ne veut pas faire.

Ce problème est très général pour les amplificateurs à large bande et ne peut pas être résolu de manière totalement satisfaisante, les risques d'oscillation apparaissant d'autant plus que la bande passante doit être plus élevée et que le gain lui aussi doit être plus élevé. Seuls des compromis permettent d'atteindre les spécificatons que l'on se fixe.

La présente invention propose une nouvelle astuce pour repousser le risque d'oscillation en maintenant le produit gain × bande passante aussi large que possible (ce produit étant une grandeur caractéristique des performances de l'amplificateur).

Plus précisément, l'invention concerne un amplificateur différentiel comprenant un étage différentiel et un étage suiveur, l'étage différentiel comprenant une branche commune reliée entre une première borne d'alimentation A et le point de jonction de deux branches différentielles reliées par ailleurs à une deuxième borne d'alimentation B, la branche commune comportant deux transistors en parallèle T5. T10 dont les grilles sont commandées séparément à partir de sorties S1, S2, respectives de l'étage différentiel, et chaque branche différentielle comportant un transistor d'entrée T1, T2 en série avec un transistor de charge T3, T4, l'étage différentiel ayant deux entrées E1, E2. respectivement reliées aux grilles des transistors d'entrée T1. T2 des branches différentielles, et deux sorties S1. S2 qui sont les points de jonction des transistors d'entrée T1. T2 avec les transistors de charge T3. T4. une première sortie S1 étant reliée à l'entrée de l'étage suiveur T6. T7 et la sortie de cet étage suiveur constituant la sortie de l'amplificateur, du type dans lequel une première branche de contre-réaction de mode commun T8, T9 formant un étage suiveur est reliée entre une deuxième sortie S2 de l'étage différentiel et la grille d'un transistor respectif T5 de ladite branche commune, caractérisé en ce qu'il est prévu une deuxième branche de contre-réaction de mode commun formant un étage suiveur, reliée entre ladite première sortie S1 de l'étage diffrentiel et la grille de l'autre transistor T10 de ladite branche commune, et en ce qu'une capacité C2 est connectée entre la deuxième sortie S2 de l'étage différentiel et la deuxième borne d'alimentation B, de telle sorte que la capacité équivalente C'2 entre cette deuxième sortie S2 et la deuxième borne d'alimentation B soit nettement supérieure à la capacité équivalente C'1 entre la première sortie S1 et la deuxième borne d'alimentation B.

La réduction du risque d'oscillation est tout particulièrement importante si on prévoit que la conductance des transistors de charge T3, T4 est largement inférieure à la conductance des transistors d'entrée T1, T2.

L'ordre de grandeur de la capacité équivalente entre S2 et B peut être d'environ 3 à 6 fois la capacité équivalente entre S1 et B.

De préférence, on placera à la fois une capacité de compensation entre S1 et B, et une autre, nettement plus importante, entre S2 et B.

D'autres caractéristiques et avantages de l'invention apparaîtront à la lecture de la description détaillée qui suit et qui est faite en référence aux dessins annexés dans lesquels:

– la figure 1 déjà décrite représente un amplificateur de la technique antérieure,

– la figure 2 représente l'amplificateur selon l'invention.

Sur la figure 2, les éléments déjà décrits de la figure 1 sont rigoureusement repris avec les mêmes références et les mêmes liaisons entre eux.

La différence se situe dans l'adjonction d'une capacité C2 entre la borne B et la deuxième sortie S2 (celle qui n'est pas reliée à l'entrée de l'étage suiveur de sortie T6, T7), et dans l'adjonction d'une deuxième branche de contre-réaction de mode commun entre la sortie S1 et la branche commune de polarisation.

La branche commune comprend maintenant non pas un seul transistor T5, mais deux transistors en parallèle T5 et T10 (drains réunis et sources réunies), la grille du transistor T10 étant reliée au point de jonction de deux transistors T11 et T12 connectés en série entre les bornes A et B et constituant la deuxième branche de contre-réaction de mode commun.

Le transistor T11, relié à la borne B, a sa grille commandée par la première sortie S1 (celle qui est reliée par l'étage suiveur à la sortie S de l'amplificateur).

Le transistor T12, relié à la borne A, a sa grille polarisée par une tension de polarisation qui peut être la tension $V_p$ déjà mentionnée.

Enfin, une capacité C1 peut être connectée entre la sortie S1 et la borne B (comme d'ailleurs à la figure 1), pourvu cependant que la somme C'1 des capacités équivalentes vues entre les points S1 et B (incluant C1, ainsi que les capacités parasites des transistors T3, T6, T11 notamment) reste nettement inférieure à la somme C'2 des capacités équivalentes vues entre les points S2 et B (incluant C2 ainsi que les capacités parasites des transistors T4, T8 notamment).

On peut montrer, par des calculs fondés sur des modélisations électriques simples des transistors, que les capacités C1 et C2 agissent d'une part pour abaisser le pôle principal de la fonction de transfert de l'amplificateur à une fréquence liée à C'1 + C'2, de même d'ailleurs que la capacité C1 le faisait dans le schéma de la figure 1; mais de plus, les capacités C1 et C2 introduisent un couple pôle-zéro où le zéro est à fréquence plus basse que le pôle lorsque C'2 est nettement supérieur à C'1, car la fréquence du zéro est essentiellement liée à 1/C'2. tandis que la fréquence du pôle est liée à ½ (1/C'1 + 1/C'2).

L'avance de phase introduite par ce couple pôle-zéro, où le zéro est à plus basse fréquence que le pôle, entraîne un recul du risque d'oscillation sans réduction du gain de l'amplificateur. L'abaissement du pôle principal réduit aussi ce risque en réduisant la bande passante et le temps de montée de l'amplificateur, mais on peut, contrairement à ce qui était le cas dans le schéma de la figure 1. éviter une réduction excessive de la bande passante en limitant la somme C'1 + C'2 et en cherchant à obtenir l'effet principal de réduction du risque d'oscillation par un déséquilibre important de C'1 et C'2 (avec C'2 supérieur à C'1) plutôt que par une simple augmentation de la somme C'1 + C'2.

On pourrait montrer que dans un schéma tel que celui de la figure 1, l'introduction d'une autre capacité C2 entre S2 et B ne servirait qu'à déstabiliser l'amplificateur en introduisant un couple pôle-zéro ou le pôle est à plus basse fréquence que le zéro. Seule l'augmentation de la capacité C1 (entre S1 et B) et surtout pas l'augmentation de la capacité C2 contribue à abaisser le risque d'oscillation. mais par abaissement de la fréquence du pôle principal, donc avec réduction de la bande passante et du temps de montée de l'amplificateur.

Cette amélioration apportée par l'invention se fait tout particulièrement sentir lorsque la conductance des transistors d'entrée T1, T2 de l'étage différentiel est nettement supérieure à celle des transistors de charge (T3, T4) et c'est pourquoi on choisit de préférence pour ces derniers des transistors de type déplété (tension de seuil négative) ayant leur grille reliée à leur source.

A titre d'exemple, la capacité C1 peut être de 0.3 picofarad (de l'ordre de grandeur des capacités parasites) et la capacité C2 de 1,5 picofarad. pour un amplificateur de temps d'établissement de 40 nanosecondes (de 0 à 2 volts à quelques millivolts près). cet amplificateur étant destiné à un convertisseur numérique-analogique rapide.

**Revendications**

1. Amplificateur différentiel comprenant un étage différentiel et un étage suiveur. l'étage différentiel comprenant une branche commune reliée entre une première borne d'alimentation (A) et le point de jonction de deux branches différentielles reliées par ailleurs à une deuxième borne d'alimentation (B), la branche commune comportant deux transistors en parallèle (T5, T10) dont les grilles sont commandées séparément à partir de sorties (S1, S2) respectives de l'étage différentiel et chaque branche différentielle comportant un transistor d'entrée (T1, T2) en série avec un transistor de charge (T3, T4), l'étage différentiel ayant deux entrées (E1, E2), respectivement reliées aux grilles des transistors d'entrée (T1, T2) des branches différentielles, et deux sorties (S1, S2) qui sont les points de jonction des transistors d'entrée (T1, T2) avec les transistors de charge (T3, T4), une première sortie (S1) étant reliée à l'entrée de l'étage suiveur (T6, T7) et la sortie de cet étage suiveur constituant la sortie de l'amplificateur, du type dans lequel une première branche de contre-réaction de mode commun (T8, T9) formant un étage suiveur est reliée entre une deuxième sortie (S2) de l'étage différentiel et la grille d'un transistor respectif (T5) de ladite branche commune, caractérisé en ce qu'il est prévu une deuxième branche de contre-réaction de mode commun formant un étage suiveur, reliée entre ladite première sortie (S1) de l'étage différentiel et la grille de l'autre transistor (T10) de ladite branche commune et en ce qu'une capacité (C2) est connectée entre la deuxième sortie (S2) de l'étage différentiel et la deuxième borne d'alimentation (B), de telle sorte que la capacité équivalente (C'2) entre cette deuxième sortie (S2) et la deuxième borne d'alimentation (B) soit nettement supérieure à la capacité équivalente (C'1) entre la première sortie (S1) et la deuxième borne d'alimentation (B).

2. Amplificateur différentiel selon la revendication 1, caractérisé en ce qu'une autre capacité (C1) est connectée entre la première sortie (S1) de l'étage différentiel et la deuxième borne d'alimentation (B).

3. Amplificateur différentiel selon l'une des revendications 1 et 2, caractérisé en ce que les transistors de charge (T3, T4) de l'étage différentiel sont des transistors de type déplété ayant leur grille reliée à leur source.

## Patentansprüche

1. Differenzverstärker, bestehend aus einer Differenzverstärkerstufe und einer Folgerstufe, wobei die Differenzverstärkerstufe einen gemeinsamen Zweig umfaßt, der zwischen einem ersten Versorgungsanschluß (A) und dem Verbindungspunkt zweier Differenzverstärkerzweige liegt, die jeweils mit einem zweiten Versorgungsanschluß (B) verbunden sind, wobei der gemeinsame Zweig aus zwei parallelen Transistoren (T5, T10) besteht, deren Steuereingänge getrennt in Abhängigkeit von betreffenden Ausgängen (S1, S2) der Differenzverstärkerstufe angesteuert werden und jeder Differenzverstärkerzweig einen in Reihe mit einem Lasttransistor (T3, T4) geschalteten Eingangstransistor (T1, T2) enthält, wobei ferner die Differenzverstärkerstufe zwei mit den Steuereingängen der Eingangstransistoren (T1, T2) der Differenzverstärkerzweige verbundene Eingänge (E1, E2) sowie zwei Ausgänge (S1, S2) hat, welche die Verbindungspunkte der Eingangstransistoren

(T1, T2) mit den Lasttransistoren (T3, T4) bilden, sowie ein erster Ausgang (S1) mit dem Eingang der Folgerstufe (T6, T7) verbunden und der Ausgang dieser Folgerstufe mit dem Ausgang des Verstärkers verbunden ist, bei dem ein eine Folgerstufe bildender erster Zweig der Gleichtakt-Gegenkopplung (T8, T9) zwischen einem zweiten Ausgang (S2) der Differenzverstärkerstufe und dem Steuereingang eines betreffenden Transistors (T5) des genannten gemeisamen Zweiges liegt, dadurch gekennzeichnet, daß ein zweiter, eine Folgerstufe bildender Gleichtakt-Gegenkopplungszweig vorgesehen ist, der zwischen dem ersten Ausgang (S1) der Differenzverstärkerstufe und dem Steuereingang des anderen Transistors (T10) des gemeinsamen Zweiges liegt, und daß eine Kapazität (C2) zwischen dem zweiten Ausgang (S2) der Differenzverstärkerstufe und dem zweiten Versorgungsanschluß (B) in der Weise geschaltet ist, daß die Ersatzkapazität (C'2) zwischen diesem zweiten Ausgang (S2) und dem zweiten Versorgungsanschluß (B) deutlich größer ist als die Ersatzkapazität (C'1) zwischen dem ersten Ausgang (S1) und dem zweiten Versorgungsanschluß (B).

2. Differenzverstärker nach Anspruch 1, dadurch gekennzeichnet, daß eine weitere Kapazität (C1) zwischen dem ersten Ausgang (S1) der Differenzverstärkerstufe und dem zweiten Versorgungsanschluß (B) geschaltet ist.

3. Differenzverstärker nach Anspruch 1 oder 2, dadurch gekennzeichnet, daß die Lasttransistoren (T3, T4) der Differenzverstärkerstufe Transistoren vom Verarmungstyp sind, deren Steuereingänge mit ihren Source-Eingängen verbunden sind.

## Claims

1. A differential amplifier comprising a differential stage and a following stage, the differential stage comprising a common branch connected between a first supply terminal (A) and the junction point of two differential branches which are also connected to a second supply terminal (B), the common branch comprising two transistors in parallel (T5, T10) the gates of which are controlled separately from respective outputs (S1, S2) of the differential stage, and each differential branch comprising an input transistor (T1, T2) in series with a charge transistor (T3, T4), the differential stage having two inputs (E1, E2) respectively connected to the gates of the input transistors (T1, T2) of the differential branches and two outputs (S1, S2) which are the points of junction of the input transistors (T1, T2) with the charge transistors (T3, T4), a first output (S1) being connected to the input to the following stage (T6, T7) and the output of this following stage constituting the output of the amplifier of the kind in which a first branch of feedback of common mode (T8, T9) forming a following stage is connected between a second output (S2) of the differential stage and the gate of a respective transistor (T5) of the said common banch, characterized in that a second branch of feedback of common mode is provided, forming a following stage connected between the said first output (S1) of the differential stage and the gate of the other transistor (T10) of the said common branch, and in that a capacitor (C2)

is connected between the second output (S2) of the differential stage and the second supply terminal (B) in such a way that the equivalent capacitance (C'2) between this second output (S2) and the second supply terminal (B) is considerably greater than the equivalent capacitance (C'1) between the first output (S1) and the second supply terminal (B).

2. A differential amplifier according to claim 1, characterized in that another capacitor (C1) is connected between the first output (S1) of the differential stage and the second supply terminal (B).

3. A differential amplifier according to one of Claims 1 and 2, characterized in that the charge transistors (T3, T4) of the differential stage are transistors of the depleted kind having their gate connected to their source.

# FIG_1

# FIG_2